Europäisches Patentamt

European Patent Office

Office européen des brevets

(11) Publication number: **0 229 482 B1**

# EUROPEAN PATENT SPECIFICATION

(45) Date of publication of patent specification: **06.11.91**

(51) Int. Cl.⁵: **H02J 7/24, H03K 17/687, H02P 9/30, H02M 3/156**

(21) Application number: **86309376.1**

(22) Date of filing: **02.12.86**

(54) Switching circuit utilizing a field effect transistor and voltage regulator.

(30) Priority: **13.01.86 US 817986**

(43) Date of publication of application:
**22.07.87 Bulletin 87/30**

(45) Publication of the grant of the patent:
**06.11.91 Bulletin 91/45**

(84) Designated Contracting States:
**DE FR GB**

(56) References cited:
**EP-A- 0 060 336**     **WO-A-82/04349**
**DE-A- 3 021 890**     **DE-A- 3 209 070**
**US-A- 4 335 344**     **US-A- 4 603 269**

**IEE PROCEEDINGS SECTION A a I, 131, no. 4, pages 141-146; I.M. Filanovsky et al.: "Nonsymmetric multivibrators with an auxiliary RC-circuit"**

(73) Proprietor: **GENERAL MOTORS CORPORATION**
**General Motors Building 3044 West Grand Boulevard**
**Detroit Michigan 48202(US)**

(72) Inventor: **Bowman, William E.**
**3704 Sugar Lane**
**Kokomo Indiana 46902(US)**

(74) Representative: **Denton, Michael John et al Patent Section Vauxhall Motors Limited 1st Floor Gideon House 26 Chapel Street Luton Bedfordshire LU1 2SE(GB)**

## Description

This invention relates to a switching circuit that employs a field effect transistor and to a voltage regulator for a generator that utilizes the switching circuit to control the field current of a generator to thereby regulate the output voltage of the generator.

When an N-channel metal oxide semiconductor field effect transistor (MOSFET) is used in a switching circuit that is connected to a voltage source and to a load in a high side drive configuration that is, where the drain is connected to the positive terminal of the voltage source and the load is connected between the source electrode of the MOSFET and the negative terminal of the voltage source, it is necessary to provide some means in addition to the voltage of voltage source to develop a gate voltage that is applied to the gate of sufficient magnitude to gate and maintain the MOSFET conductive between its drain and source. One known method of developing a gate voltage that is higher then the voltage magnitude of the voltage source is to employ a voltage doubler, such as in US Patent No 4,420,700.

One of the objects of this invention is to provide an improved high side drive switching circuit that utilizes an N-channel field effect transistor that uses only one capacitor that serves to provide a plurality of control functions. Thus, in a switching circuit made in accordance with this invention the capacitor provides for circuit timing and it also provides a source of voltage for voltage doubling action. In addition, the capacitor is utilized when the circuit is in a certain mode of operation to cause the field effect transistor to be switched on and off to provide a series of voltage pulses that have a fixed duty cycle. This fixed duty cycle mode provides a means for exciting the field winding of a generator with an average current from a storage battery when the switching circuit of this invention is used in a voltage regulator for a motor vehicle generator.

To this end, a switching circuit in accordance with the present invention is characterised by the features specified in the characterising portion of Claim I.

More specifically, in a switching circuit in accordance with this invention current is pumped into the capacitor during a charge mode until the voltage across the capacitor reaches some predetermined value. This voltage level is detected and when it is attained, the voltage across the capacitor is stacked or added in series with the voltage across the direct voltage source to provide a gate bias voltage for the field effect transistor that is substantially the sum of the capacitor voltage and the voltage of the direct voltage source. At the time that the capacitor voltage attains the predetermined value the capacitor voltage and source voltage are stacked or added as described and at this time the circuit switches to a capacitor discharge mode wherein the capacitor begins to discharge. The capacitor now discharges until the sum of the capacitor voltage and that of the voltage source has decreased to a predetermined value or level. When this happens, that circuit switches to a capacitor charge mode wherein the capacitor begins to recharge and at the same time the capacitor voltage and voltage source are unstacked. The cycle that has been described repeats periodically that is, the capacitor is repetitively charged and discharged. During the repetitive charging and discharging of the capacitor and the stacking and unstacking of the voltage source and the capacitor voltage a junction or node in the circuit will have its voltage varied between the sum voltage (stacked condition) and the voltage across the capacitor (unstacked condition). This node or junction is connected to the gate of the field effect transistor. During the stacked condition the sum voltage is sufficient to gate the field effect transistor conductive between its drain and source. Moreover, when the capacitor is discharging the voltage that the capacitor discharges down to is such that the sum voltage (stacked voltages) is high enough to maintain the field effect transistor biased conductive. The repetitive charging and discharging of the capacitor and the stacking and unstacking of the capacitor voltage and the voltage of the voltage source develops a gate bias voltage for a period of time that substantially corresponds to the time period that the capacitor is discharging. This period of time is substantially constant and is a function of the RC time constant of the capacitor discharge circuit. The gate bias voltage is high enough throughout the discharge period of the capacitor to maintain the field effect transistor biased conductive.

In order to control the time periods that that field effect transistor is biased conductive and nonconductive a switching device is connected between the gate of the field effect transistor and the negative terminal of the voltage source. When this switching device is nonconductive the field effect transistor is in a condition to be biased conductive by the gate voltage that is developed and when the switching device is conductive the field effect transistor is biased nonconductive. The switching state of the switching device is controlled such that it can change its state only at a time when that capacitor has charged to the predetermined voltage level. With this arrangement the field effect transistor can be biased conductive for a total time period that is equal to the sum of a plurality of consecutive occurring time periods of equal duration. Moreover, when the switching device goes conductive the field effect transistor can be biased nonconductive for a total time period that is equal to the sum of a plurality of consecutive occurring time periods of equal duration. The gate drive voltage that is developed at the junction or node has negative voltage transitions that occur during the time that the capacitor is charging. In order to prevent these transitions from lowering the voltage applied to the gate of the field effect transistor to a value that might not be sufficient to maintain the field effect transistor gated conductive a filter circuit is provided which is comprised of the gate capacitance of the field effect transistor and a resistor that is connected to the gate of the field effect transistor.

In accordance with another aspect of this invention the switching circuit is arranged such that it can operate in a duty cycle mode wherein the field effect transistor is gated on and off to provide voltage pulses of a fixed duty cycle. In order to provide this mode of operation the capacitor is repetitively charged and discharged in a manner that has been described. However, when the capacitor is discharging and the voltage stacking has occurred the gate of the field effect transistor is connected to the negative terminal of the voltage source to bias the field effect transistor nonconductive at a point in time when the gate voltage decreases to a level that is higher in voltage than a level which causes the capacitor to be placed in its charging mode. With this arrangement the field effect transistor is biased conductive for consecutive occurring equal time periods that corresponds to a certain percentage of the discharge time of the capacitor.

Another object of this invention is to provide a voltage regulator for a (diode-rectified alternating current) generator that utilizes the switching circuit that has been described for gating a field effect transistor that controls generator field current on and off as a function of magnitude of the output voltage of the generator to thereby maintain the generator output voltage at a desired regulated value.

A voltage regulation in accordance with the present invention is provided with the features of Claim 6.

In the achievement of this object the drain electrode of the field effect transistor is connected to the positive output terminal of the generator and the field winding is connected between the source electrode and the negative output terminal of the generator. The gate of the field effect transistor is supplied with a gate bias voltage by the circuitry that has been described. When the voltage regulator is in the normal regulating mode and when the output voltage of the generator is below a desired regulated value the field effect transistor is biased conductive for a total time period that is equal to the sum of a plurality of consecutive occurring time periods of equal duration. When the generator output voltage increases to a level that is above the desired regulated value the field effect transistor is biased nonconductive for a total time period that is equal to the sum of a plurality of consecutive occurring time periods of equal duration. These consecutively occurring time periods are shorter in duration than the consecutively occurring time periods that are developed when the generator output voltage is below the desired regulated value.

An important advantage of the voltage regulator of this invention is that the voltage regulator is not a so-called ripple regulator, that is it is not affected by the magnitude or period of the ripple voltage that appears at the direct voltage output terminals of the bridge rectifier that is connected to the (alternating current) generator.

Still another object of this application is to provide a voltage regulator of the type that has been described that can be shifted from a normal regulation mode of operation to a field strobing mode of operation. The voltage regulator is arranged to shift to the field strobing mode when the rotor of the generator is not rotating or is being rotated at a speed that is below a predetermined speed. In the field strobing mode the field is energized from the storage battery of a motor vehicle electrical system through the field effect transistor which is gated on and off. The field effect transistor is gated on and off in such a manner that the field is energized for consecutive occurring equal time periods that have a certain duty cycle. This is achieved in a manner described above in connection with the description of the duty cycle mode of operation of the switching circuit.

The present invention is now described, by way of example, with reference to the accompanying drawings, in which:-

Figure I is a schematic circuit diagram of a voltage regulator for a generator that utilizes a switching circuit in accordance with this invention;

Figure 2 is a schematic circuit diagram of the control circuit which is shown as a block in Figure I; and

Figure 3 illustrates a voltage waveform of a voltage that is developed by the control circuit shown in Figure 2.

The switching circuit of this invention will now be described in connection with a use as a voltage regulator for controlling the field current of a generator that is of the diode-rectified alternating current type that supplies the electrical loads on a motor vehicle including the storage battery. In this type of use the switching of a field effect transistor controls field current. The use of the switching circuit is not limited to voltage regulator use and it can be used to control the voltage or current supplied to electrical loads other than a generator field load.

Referring now to the drawings and more particularly to Figure l, a generator l0 which has an output winding l2 which is three-phase Delta connected and field winding l4. The output winding l2 may be Y-connected. The field winding l4 is carried by a generator rotor which is driven by an engine l5 of a motor vehicle in a manner well known to those skilled in the art. The magnitude of the output voltage, that is generated in the output winding l2, is a function of the magnitude of the field current supplied to the field winding l4. This field current is controlled by the voltage regulator of this invention in a manner to be described hereinafter.

The output winding l2 is connected to AC input terminals of a bridge rectifier l6 of the three-phase full-wave type, which is comprised of three positive diodes l8 and three negative diodes 20. The cathodes of the positive diodes l8 are connected to a positive direct voltage output terminal 22 of the bridge rectifier l6. The anodes of the positive diodes 20 are connected to a negative direct voltage output terminal 24 of the bridge rectifier l6. The negative direct voltage output terminal 24 is grounded.

The positive direct voltage output terminal 22 is connected to a conductor 26 which in turn is connected to a junction 28. A storage battery 30 has its positive terminal connected to the junction 28 and has a negative terminal that is grounded. An electrical load 32 is shown with a switch 34 connected between the electrical load 32 and the junction 28. In a motor vehicle electrical system there are a plurality of electrical loads and switches connected between the junction 28 and ground. The junction 28 is connected to a conductor 36.

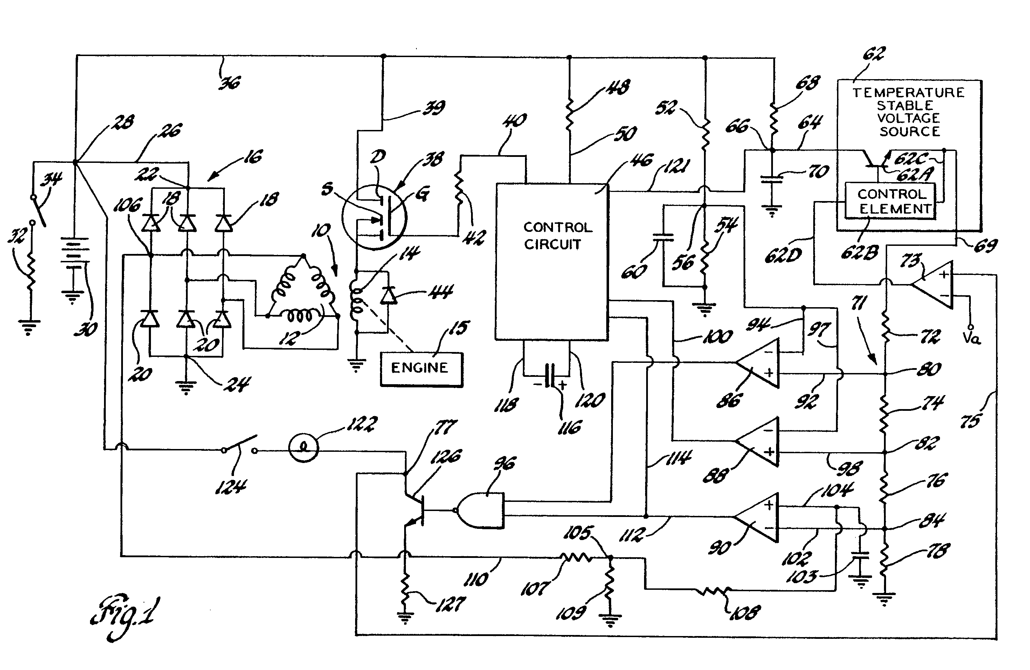

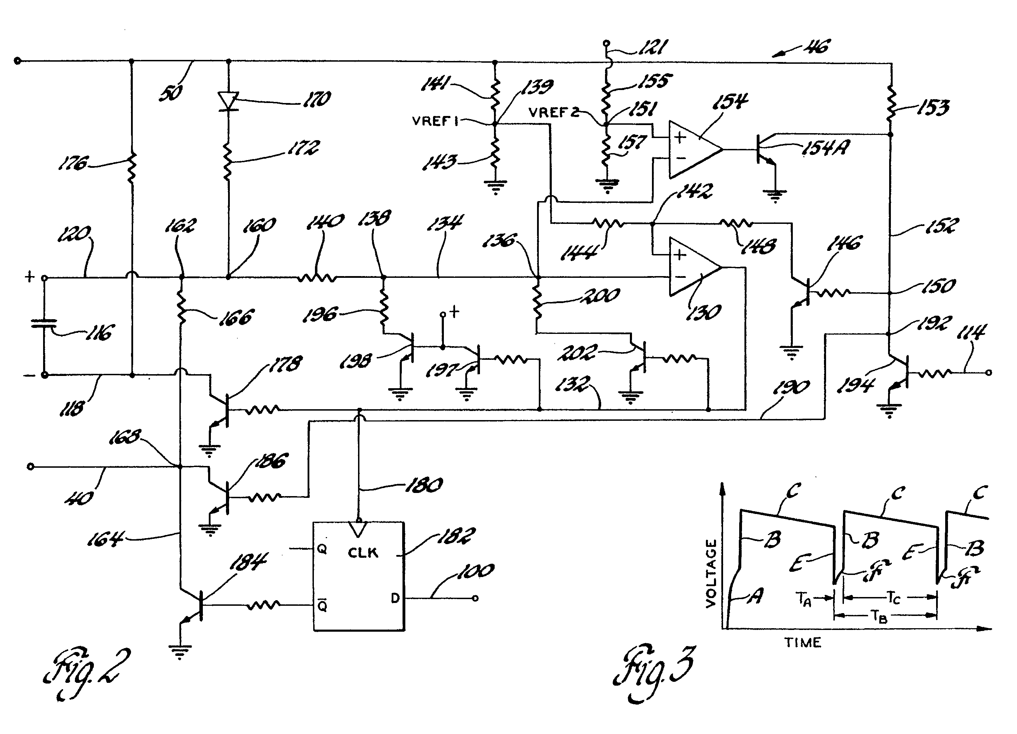

The voltage regulator of this invention comprises a metal oxide semiconductor field effect transistor (MOSFET) 38 that has a drain D, a gate G and a source S. This MOSFET 38 is an N-channel enhancement mode type of field effect transistor. The drain D is connected to the conductor 36 by a conductor 39. The gate G is connected to a conductor 40 by a resistor 42. The source S is connected to one side of the field winding l4. The opposite side of the field winding l4 is grounded. A field discharge diode 44 is connected across the field winding l4. The circuit for energizing the field winding l4 can be traced from the junction 28 to the conductors 36 and 39, through the drain D and source S of the MOSFET 38 and then through the field winding l4 to ground. The MOSFET 38 is biased conductive and nonconductive to control field current by a control circuit 46 which is shown in block diagram form in Figure l and in detail in Figure 2. The gate G of MOSFET 38 is connected to the control circuit 46 via the conductor 40 and the resistor 42. The control circuit 46 is also connected to the conductor 36 by a resistor 48 and a conductor 50.

The voltage regulator has a voltage dividing voltage sensing circuit comprised of resistors 52 and 54 that are series connected between the conductor 36 and ground. The resistors 52 and 54 have a junction 56. A capacitor 60 is connected across the resistor 54. The resistors 52 and 54 function as a voltage divider and accordingly the voltage at the junction 56 is a divided down representative of the voltage between the conductor 36 and ground. Since the conductor 36 is connected to the junction 28 the voltage at the junction 56 will vary in accordance with variation in the voltage across the storage battery 30 and this voltage is a function of the magnitude of the output voltage of the generator l0. The voltage regulator controls the switching of the MOSFET 38 to thereby vary field current to maintain the voltage appearing between the junction 28 and ground substantially constant. In a l2 volt motor vehicle electrical system the regulated voltage to be maintained between the junction 28 and ground may be about l4 volts.

The voltage regulator has a temperature stable voltage source 62. This temperature stable voltage source 62 has an input connected to a conductor 64. The conductor 64 is connected to a junction 66. This junction 66 is connected to the conductor 36 by a resistor 68. A capacitor 70 is connected between the junction 66 and ground. The temperature stable voltage source 62 has an output connected to a conductor 69. The purpose of the temperature stable voltage source 62 is to maintain a substantially constant voltage on the conductor 69. The temperature stable voltage source 62 has been illustrated somewhat schematically since regulators or voltage sources of this type are well known to those skilled in the art. Thus, the temperature stable voltage source 62 comprises an NPN transistor 62A connected between the conductors 64 and 69. The base of the NPN transistor 62A is connected to a control element 62B which serves to control the conduction of the NPN transistor 62A. The control element 62B responds to the voltage on the conductor 69 via a conductor 62C and controls the conduction of the NPN transistor 62A to maintain a regulated constant voltage on the conductor 69. The control element 62B also responds to the output of a low voltage comparator 73 via a conductor 62D. The low voltage comparator 73 compares the voltage on a conductor 75 with a reference voltage $V_a$. The conductor 75 is connected to a junction 77 that is connected between a signal lamp l22 and the collector of an NPN transistor l26. If the voltage on the conductor 75 does not exceed a certain minimum predetermined value the output of the low voltage comparator 73 will cause the control element 62B to bias the NPN transistor 62A nonconductive to thereby disconnect the conductors 64 and 69. If the voltage on the conductor 75 exceeds the predetermined minimum value the NPN transistor 62A is controlled to conduct to thereby cause a regulated voltage to be developed on the conductor 69.

The output voltage of the temperature stable voltage source 62 on the conductor 69 is applied to a voltage divider 71 comprised of resistors 72, 74, 76 and 78 that are series connected between the conductor 69 and ground. The voltage divider has junctions 80, 82 and 84. The temperature stable voltage source 62 applies a substantially constant voltage that does not vary substantially with variations in temperature to the voltage divider 71. The voltages at junctions 80, 82 and 84 progressively decrease due to the voltage division provided by the voltage divider 71.

The voltage regulator has an overvoltage comparator 86, a setpoint comparator 88 and a generator phase voltage responsive comparator 90. The direct voltage source for these comparators is the voltage on the conductor 69 and these comparators are connected to the conductor 69 in a conventional manner by conductors which have not been illustrated. The overvoltage comparator 86 compares the voltage on a conductor 92 with the voltage on a conductor 94. The conductor 94 is connected to the junction 56 and the conductor 92 is connected to the junction 80. The output of the overvoltage comparator 86 is connected to a NAND gate 96.

The setpoint comparator 88 compares the voltage on a conductor 97 with the voltage on a conductor 98. The conductor 98 is connected to the junction 82 and the conductor 97 is connected to the junction 56. The setpoint comparator 88 therefore compares a constant reference voltage (junction 82) with a voltage that varies with changes in the output voltage of the generator 10 (junction 56). The output of setpoint comparator 88 is connected to the control circuit 46 by a conductor 100.

The generator phase voltage responsive comparator 90 compares the voltage on a conductor 102 with the voltage on a conductor 104. The conductor 102 is connected to the junction 84 of voltage divider 71. The conductor 104 is connected to a junction 105 of resistors 107 and 109 through a resistor 108. A capacitor 103 is connected between the conductor 104 and ground. One end of the resistor 107 is connected to a junction 106 of one of the AC input terminals of the bridge rectifier 16 by a conductor 110. One end of the resistor 109 is grounded. The output of the generator phase voltage responsive comparator 90 is connected to the NAND gate 96 via a conductor 112 and to the control circuit 46 via a conductor 114. When the

rotor of the generator 10 that carries the field winding 14 is not rotating there will be no voltage generated at the junction 106. In the event that the field winding 14 is open there likewise will be no voltage generated by the generator 10 and accordingly no voltage developed at the junction 106. With no voltage developed at the junction 106 (open field or no generator rotor rotation) the relative voltages on conductors 102 and 104 are such as to cause the output of the generator phase voltage responsive comparator 90, that is applied to the conductors 112 and 114, to go low or to a zero voltage level which may be substantially ground potential. When generator output voltage builds up toward the desired regulated value the voltage at the conductor 104 will eventually exceed the voltage on the conductor 102 which will cause the output of the generator phase voltage responsive comparator 90 to go to a high positive voltage or to what may be termed a one level. This will occur when the rotor of the generator 10 has been brought up to a predetermined speed by the engine 15 that drives the generator rotor.

The control circuit 46 is connected to a capacitor 116 by conductors 118 and 120. The function of the capacitor 116 will be described hereinafter in connection with a detailed description of the control circuit 46 shown in Figure 2. The control circuit 46 is also connected to the junction 66 by a conductor 121.

The voltage regulator of Figure 1 includes the signal lamp 122, one side of which is connected to an ignition switch 124 which is manually operable. The ignition switch 124 is connected between the signal lamp 122 and the junction 28. Energization of the signal lamp 122 is controlled by a semiconductor switch provided by the NPN transistor 126. The collector of the NPN transistor 126 is connected to one side of the signal lamp 122 and its emitter is grounded through a resistor 127. The base of NPN transistor 126 is connected to the output of the NAND gate 96 which biases the NPN transistor 126 either conductive or nonconductive. When the ignition switch 124 is closed and the NPN transistor 126 is biased conductive the signal lamp 122 is energized.

Referring now to Figure 2 the control circuit 46, which is illustrated as a block in Figure 1, will now be described. In Figure 2 the same reference numerals have been used as were used in Figure 1 to identify corresponding conductors. In Figure 2 a timing comparator 130 is shown having an output connected to a conductor 132. The negative input terminal of the timing comparator 130 is connected to a conductor 134 which is connected to junctions 136 and 138 and one side of a resistor 140. The positive input terminal of the timing comparator 130 is connected to a positive reference voltage VREF1

provided at a junction 139 of resistors 141 and 143 of a voltage divider which are series connected between the conductor 50 and ground. The connection to the positive input terminal of the timing comparator 130 is made via a junction 142 and a resistor 144. The junction 142 is connected to one side of a semiconductor switch or gate which takes the form of an NPN transistor 146. The collector of the NPN transistor 146 is connected to the junction 142 through a resistor 148. The emitter of the NPN transistor 146 is grounded and its base is connected to a junction 150 on a conductor 152.

The control circuit 46 has another voltage comparator 154 that includes a switching device comprised of an NPN transistor 154A. The collector of the NPN transistor 154A is connected to the conductor 152 and its emitter is grounded. When the NPN transistor 154A is conductive it grounds the conductor 152. A resistor 153 is connected between the conductors 152 and 50. The negative input terminal of the voltage comparator 154 is connected to the junction 136. The positive input terminal of the voltage comparator 154 is connected to a positive reference voltage VREF2 developed at a junction 151 of resistors 155 and 157 of a voltage divider connected between the conductor 121 and ground. Reference voltage VREF2 has a larger magnitude than reference voltage VREF1.

The conductor 120, which is connected to one side of the capacitor 116, is connected to one side of the resistor 140 and to junctions 160 and 162. The junction 162 is connected to a conductor 164 through a resistor 166. The conductor 164 is connected to a junction 168 which in turn is connected to the conductor 40 and therefore to the gate G of the MOSFET 38 through the resistor 42.

A diode 170 and resistor 172 are series connected between the conductor 50 and the junction 160. A resistor 176 is connected between the conductor 50 and the conductor 118. The conductor 118 is connected to one side of a gate or semiconductor switch which takes the form of an NPN transistor 178. The collector of the NPN transistor 178 is connected to the conductor 118 and its emitter is grounded. The base of the NPN transistor 178 is connected to the conductor 132 and a conductor 180. The conductor 180 is connected to the clock input of a flip-flop 182 of the negative edge triggered D-type. The D terminal of flip-flop 182 is connected to the conductor 100 which is connected to the output of the setpoint comparator 88. The $\overline{Q}$ terminal of flip-flop 182 is connected to the base of an NPN transistor 184. The collector of the NPN transistor 184 is connected to the conductor 164 and its emitter is grounded. The NPN transistor 184 provides a semiconductor switch or gate.

A gate or semiconductor switch is connected between the junction 168 and ground and it takes the form of an NPN transistor 186. The collector of the NPN transistor 186 is connected to the junction 168 and its emitter is grounded. The base of the NPN transistor 186 is connected to a conductor 190 which in turn is connected to the conductor 152 at a junction 192. A gate or semiconductor switch which takes the form of an NPN transistor 194 is connected between the junction 192 and ground. The collector of the NPN transistor 194 is connected to the junction 192 and its emitter is grounded. The base of the NPN transistor 194 is connected to the conductor 114 and accordingly to the output of the generator phase voltage responsive comparator 90.

A gate or semiconductor switch is connected between the junction 138 and ground through a resistor 196. This gate or semiconductor switch takes the form of an NPN transistor 198, the collector of which is connected to the resistor 196. The emitter of the NPN transistor 198 is grounded and its base is connected to the collector of an NPN transistor 197. The base of the NPN transistor 197 is connected to the conductor 132 and its emitter is grounded. When the voltage on the conductor 132 is high the NPN transistor 198 is biased nonconductive and when the voltage on the conductor 132 is low the NPN transistor 198 is biased conductive.

Another gate or semiconductor switch is connected between the junction 136 and ground through a resistor 200. This gate or semiconductor switch takes the form of an NPN transistor 202 having its collector connected to the resistor 200 and its emitter grounded. The base of the NPN transistor 202 is connected to the conductor 132.

The operation of the voltage regulator will now be described with particular emphasis on the operation of the control circuit 46 shown in detail in Figure 2. In describing the operation of the control circuit 46 reference will be made to Figure 3 which illustrates the voltage developed between the conductor 120 and ground at various time periods when the voltage regulator is operating in a normal regulation mode. In describing this operation it will be assumed that the generator 10 is being driven by the engine 15 at a speed that is sufficient to develop a voltage at the junction 106 that is high enough to cause the generator phase voltage regulating comparator 90 to develop a high or one level voltage on the conductors 112 and 114. The voltage regulator is now operating in its regulation mode. With a high voltage on the conductor 114, the NPN transistor 194 is biased conductive thereby causing the NPN transistors 146 and 186 to be biased nonconductive. Assume further that the output voltage of the generator 10 is such that the voltage between the junction 28 and ground is below the desired regulated value to be maintained by the voltage regulator. Under this condition of operation more field current should be applied to the field winding l4 in order to increase the voltage generated by the generator l0. The output of the setpoint comparator 88 is now high or at a one level because the actual output voltage of the generator l0 is such that the voltage at the junction 56 (sensed voltage) is less than the voltage at the junction 82 (reference voltage). Accordingly the voltage on the conductor l00 is high or at a high level.

Initially the capacitor ll6 has no voltage across it and the output of the timing comparator l30 that is applied to the conductor l32 is at a high or one level. The high level voltage on the conductor l32 biases the NPN transistors l78 and 202 conductive and biases the NPN transistor l98 nonconductive. Since the NPN transistor l78 is conductive, the capacitor ll6 charges through the diode l70, the resistor l72, the conductor l20, the capacitor ll6, the conductor ll8 and the collector and emitter of the NPN transistor l78. The capacitor ll6 charges along the portion A of the waveform illustrated in Figure 3. Since the NPN transistor 202 is conductive, the resistors l40 and 200 are connected in series across the capacitor ll6. These resistors l40,200 form a voltage divider having the junction l36 which has a voltage that is a divided representation of the voltage across the capacitor ll6. When the capacitor ll6 charges up to a voltage such that voltage at the junction l36 equals the voltage VREFl, the output of the timing comparator l30 switches from a high state to a low state. When the output of the timing comparator l30 goes low, the NPN transistors l78 and 202 are biased nonconductive and the NPN transistor l98 is biased conductive. When the NPN transistor l78 goes nonconductive, there no longer is a charge path for the capacitor ll6. In addition the voltage on the capacitor ll6 is now added in series to the voltage on the conductor 50 and applied across the gate G and source S of the MOSFET 38. Thus, the positive capacitor voltage on the conductor l20 is applied to the gate G of the MOSFET 38 via the resistor l66 and the conductor 40. The negative end of the capacitor ll6 is connected to the positive voltage on the conductor 50 by the resistor l76. What has just been described provides a voltage doubling action. The addition or what may be termed the stacking of the voltages causes the voltage transition B shown in Figure 3. This gate bias voltage that is developed at the conductor l20 is high enough to bias the MOSFET 38 conductive and maintains it conductive in a manner to be more fully described hereinafter.

When the output of the timing comparator l30 went low, as described above, the NPN transistor 202 was biased nonconductive and the NPN transistor l98 conductive. Under this condition of operation the resistor 200 is disconnected from ground and resistors l40 and l96 are now series connected to form a discharge circuit or path for the capacitor ll6. The capacitor ll6 now discharges through the conductor l20, the resistors l40 and l96, the storage battery 30, the resistor 48 and the resistor l76 to the conductor ll8. Charge is removed from the capacitor ll6 via the resistor l66 and placed on the gate G during the discharge period of the capacitor ll6. When the capacitor ll6 begins to discharge, the voltage at the junction l62 is the voltage on the conductor 50 added to the capacitor voltage. A divided down representation of this voltage is provided at the junction l38 by the resistors l40 and l96 that provide a voltage divider. As the capacitor ll6 discharges the voltage at the junction l62 decreases exponentially along line C shown in Figure 3 and a divided down representation of this voltage is developed at the junction l38. When the voltage at the junction l38 decreases to a level where it equals VREFl the output of the timing comparator l30 switches from a low state back to a high state. When this happens the voltage at the junction l62 makes a sharp negative transition E shown in Figure 3. The cycle of operation now repeats, beginning with the charging of the capacitor ll6 when the NPN transistor l78 goes conductive. Repeated cycles of operation are illustrated in Figure 3 where repeated charging voltage transitions are designated F.

In Figure 3 the time period $T_A$ is the time period that the capacitor ll6 is in a charging mode which corresponds to the time period that the NPN transistor l78 is conductive. The time period $T_B$ is a timing period of one cycle of operation, that is the time period $T_A$ (charge time) added to a time period $T_C$ that the capacitor ll6 is in a discharge mode. The time period $T_C$ that the capacitor ll6 is in a discharge mode corresponds to the time period that the NPN transistor l78 is nonconductive. Putting it another way, time period $T_B$ is the time period between consecutive occurring initiations of the charging mode for the capacitor ll6. The timing period $T_A$ is very short as compared to timing period $T_B$. By way of example, timing period $T_B$ may be about 2.5 to 3 milliseconds and timing period $T_A$ about l00 microseconds.

Each time the capacitor ll6 attains its predetermined charging voltage (at the end of time period $T_A$) the output of the timing comparator l30 switches to a low state and this voltage transistion (high to low) is applied to the clock input of the flip-flop l82 to clock the state of the conductor l00 (high or low) to $\overline{Q}$ output of the flip-flop l82 and accordingly to the base of the NPN transistor l84. The flip-flop l82, when clocked, inverts the state of the voltage then on the conductor l00. Thus, if the conductor l00 is high when the flip-flop l82 is clocked the $\overline{Q}$ output will go low and vice versa. The $\overline{Q}$ output maintains the state it has been clocked into and can only change its state when a clock pulse on

the conductor 180 occurs.

Assuming now that the generator output voltage is below the desired regulated value the conductor 100 will have a high or one level. Assume further that the $\overline{Q}$ output of the flip-flop 182 has been clocked to a low level the NPN transistor 184 is biased nonconductive. Accordingly the junction 168, which is connected to the gate of the MOSFET 38, is not grounded by the NPN transistor 184. In the condition of operation that has been described the capacitor 116 will continue to charge and discharge during consecutive occurring cycles or timing periods $T_B$ and the MOSFET 38 will be gated conductive for a time period that corresponds substantially to the sum of a plurality of consecutively occurring timing periods $T_B$. In this regard, it is noted that at the point in time when the discharge mode of the capacitor 116 is completed and the charging mode begins, the voltage at the junction 162 will suddenly decrease by the magnitude of the voltage between the conductor 50 and ground since this voltage is not now being added to the voltage on the capacitor 116 due to the fact that the NPN transistor 178 is now conductive to thereby ground the conductor 118. This decrease in voltage is the voltage transition E shown in Figure 3. Even though the voltage at the junction 162 experiences this sharp drop the MOSFET 38 is nevertheless maintained biased conductive. Thus, the gate capacitance of the MOSFET 38, together with the resistor 42, form an RC filter which smoothes the voltage applied to the gate of the MOSFET 38 so that the gate G and source S do not experience a sharp decreasing voltage transistion and the MOSFET 38 remains biased conductive. The resistor 42 may be about 50K ohms and the gate capacitance of MOSFET 38 may be about 2000 picofarads.

The voltage magnitude that the capacitor 116 discharges down to during time period $T_C$ must be high enough so that when it is added to the voltage on the conductor 50 a resultant gate voltage on the junction 162 is high enough to keep the MOSFET 38 biased fully on. The capacitor charge time $T_A$ must be short with respect to the RC time constant of the gate capacitance of the MOSFET 38 and the resistor 42.

As long as generator output voltage is below the desired regulated value (one voltage level on the conductor 100) the MOSFET 38 will remain biased continuously conductive for a total time period that is equal substantially to the sum of a plurality of consecutively occurring time periods $T_B$. This is further explained hereinafter in connection with the mode of operation wherein the output voltage of the setpoint comparator 88 on the conductor 100 goes from a one level to a zero level which is caused by generator output voltage going above the desired regulated value.

Assume now that sufficient field current has been supplied to the field winding 14 so that the output voltage of the generator 10 increases to a value such that the voltage between the junction 28 and ground (voltage applied to the storage battery 30) exceeds the desired regulated value. At the time that generator output voltage exceeds the desired regulated value the voltage on the conductor 100 will go from a one level to zero level so that the voltage at the D input terminal of the flip-flop 182 is now at a zero level. The $\overline{Q}$ output of the flip-flop 182 is still at a low level so that the MOSFET 38 remains biased conductive. Eventually a clock pulse will be applied via the conductor 180 to the clock input of the flip-flop 182 to cause the $\overline{Q}$ output voltage level to go from a low level to a high level thereby biasing the NPN transistor 184 conductive. The clock pulse is generated on the conductors 132 and 180 at the end of the charge mode of the capacitor 116 or at the end of timing period $T_A$. When the $\overline{Q}$ voltage went high to bias the NPN transistor 184 conductive the NPN transistor 184 connects the junction 168 to ground thereby grounding the conductor 40 that is connected to the gate G of the MOSFET 38.

Accordingly, the MOSFET 38 is biased nonconductive to cutoff field current and the output voltage of the generator 10 decreases. During this mode of operation the capacitor 116 continues going through consecutive cycles or timing periods $T_B$ wherein the capacitor continues to be charged and discharged. The timing period $T_B$ during this mode of operation is decreased as compared to the mode wherein the the MOSFET 38 is biased conductive because the discharge time $T_C$ of the capacitor 116 is decreased. Thus, when the NPN transistor 184 is biased conductive to cause the MOSFET 38 to be biased nonconductive, the conducting NPN transistor 184 connects the resistor 166 to ground. The discharge path for the capacitor 116 now comprises the resistors 140 and 196 connected in parallel with the resistor 166 which causes the discharge time period of the capacitor 116 to be smaller than it was when the NPN transistor 184 was biased nonconductive. The time period that the MOSFET 38 is biased nonconductive will correspond substantially to at least one timing period $T_B$ and in most or all cases will be equal to the sum of a number of consecutively occurring time periods $T_B$. This is caused by the fact that when the voltage on the conductor 100 is low or zero, causing the MOSFET 38 to be biased nonconductive, the MOSFET 38 cannot be subsequently biased conductive until the voltage on the conductor 100 goes to a high state and this high state subsequently clocked by the flip-flop 182 when a clock pulse is applied to the conductor 180 at the end of time period $T_A$. When occurs the one level voltage

on the conductor 100 is translated into a zero level voltage at the $\overline{Q}$ output of the flip-flop 182 which in turn causes the NPN transistor 184 to be biased nonconductive and the MOSFET 38 conductive.

The normal regulation mode of operation of the voltage regulator can be summarized as follows:

(1) Regardless of the level of voltage on the conductor 100 the capacitor 116 charges and discharges over consecutively occurring timing periods $T_B$.

(2) When the voltage on the conductor 100 is high or at a one level, which is indicative of a generator output voltage that is lower than the desired regulated value, the MOSFET 38 is biased conductive and it remains biased conductive for at least one timing period $T_B$ and in most or all cases for a time period that is equal to the sum of a plurality of consecutively occurring timing periods $T_B$.

(3) When the voltage on the conductor 100 is low or at a zero level, which is indicative of a generator output voltage that is higher than the desired regulated value, the MOSFET 38 is biased nonconductive and remains nonconductive for at least one timing period $T_B$ and in most or all cases for a time period that is substantially equal to the sum of a plurality of consecutively occurring time periods $T_B$. In this case the timing period $T_B$ is shorter than the case where generator output voltage is below the desired regulated value as has been explained above. This is because the discharge period of the capacitor 116 is shorter. Because of this shorter discharge period the system can go from a mode wherein the MOSFET 38 is nonconductive to a conductive mode in a somewhat shorter period of time than when going from a conductive to a nonconductive mode.

(4) The change in the conductive or nonconductive state of the NPN transistor 184 and hence a change in the switching state of the MOSFET 38 occurs after the voltage on the conductor 100 has changed state and then only after a clock pulse has been developed on the conductors 132 and 180. The clock pulse is developed at the end of the charge period of the capacitor 116 or, in other words, at the end of timing period $T_A$.

The foregoing description has described the normal regulation mode of operation wherein the generator 10 is being driven at a sufficient speed to cause the voltage on the conductor 114 to be at a high or one level.

Assume now that the generator 10 is not being driven by the engine 15 or in other words the rotor of the generator is not rotating, there will be no voltage developed at the junction 106 and accordingly the output of the generator phase voltage responsive comparator 90, which is applied to the

conductor 114, will be at a low or zero level. This will cause the NPN transistor 194 to be biased nonconductive. In the normal regulation mode, which has been described, generator speed is high enough to cause the voltage at the conductor 114 to be at a high or one level thereby biasing the NPN transistor 194 conductive which connects the junction 192 to ground. Assuming again no generator rotation, the capacitor 116 charges in the same manner that has been described to a voltage level where the voltage at the junction 136 equals VREFI whereupon the timing comparator 130 causes the battery voltage to be stacked or added to the capacitor voltage. At this time the timing comparator 130 places the circuit in a capacitor discharge mode and the capacitor 116 therefore starts to discharge. When the voltages are added or stacked the voltage at the conductor 134 and the junction 136 accordingly sharply increases due to the stacking or voltage addition and it is applied to the negative input terminal of the voltage comparator 154. This voltage goes higher than the reference voltage VREF2 applied to the positive input terminal of the voltage comparator 154 from the junction 151 and the output of the voltage comparator 154 causes the NPN transistor 154A to be biased conductive to thereby ground the conductor 152. This causes the NPN transistors 146 and 186 to be biased nonconductive. With the NPN transistor 186 biased nonconductive the junction 168 is not grounded and accordingly the voltage at the junction 162 will bias the MOSFET 38 conductive. The field winding 14 is now energized by the storage battery 30. When the capacitor 116 discharges the voltage applied to the negative terminal of the voltage comparator 154 decreases and when it drops to VREF2 the voltage comparator 154 switches to a state wherein the NPN transistor 154A is biased nonconductive. This causes the NPN transistor 146 to be biased conductive. The conduction of the NPN transistor 146 causes the voltage at the junction 142 to be provided by a voltage divider comprised of the resistors 144 and 148 instead of only through the resistor 144. The reference voltage applied to the positive terminal of the timing comparator 130 from the junction 142 has accordingly been reduced or attenuated and the discharge period of the capacitor 116 will be increased since it will take longer for the voltage on the junction 136 to drop to the value of the voltage at the junction 142. When the voltage on the junction 136 decreases to VREF2 as the capacitor 116 discharges the conductor 152 is disconnected from ground by the nonconductive state of the NPN transistor 154A and accordingly the voltage on the conductors 152 and 190 will bias the NPN transistor 186 conductive thereby grounding the conductor 40 and causing the MOSFET 38 to be biased nonconductive. Moreover, the voltage on

the conductor 152 will bias the NPN transistor 146 conductive thereby connecting one end of the resistor 148 to ground. The resistors 144 and 148 now form a voltage divider having the junction 142, as previously explained.

In the mode of operation that has just been described, the MOSFET 38 is biased conductive when voltage stacking or addition occurs and is biased nonconductive during the discharge period of the capacitor 116, at a point in time when the voltage on the conductor 134 drops to the value VREF2. This occurs prior to the time that the voltage on the conductor 134 drops to the voltage at the junction 142. When the voltage drops to VREF2, the MOSFET 38 is biased nonconductive to cutoff field current and when it drops to a lower voltage the discharge mode for the capacitor 116 is terminated and the charge mode begins. The circuit, including the magnitudes of VREF1 and VREF2, is arranged such that during this mode of operation the MOSFET 38 is biased conductive for about 27% of a timing period or in other words a 27% duty cycle. The timing period corresponds to the discharge period of the capacitor 116. The consecutive occurring conductive periods of the MOSFET 38 occur at a constant frequency and a fixed duty cycle of substantially 27%. This mode of operation may be termed the field strobing mode and operates to excite the field winding 14 from the storage battery 30 with an average current that is sufficient to cause the generator output voltage to buildup when the generator rotor is rotated. The field strobing mode is operative whenever there is no rotation of the generator rotor and the ignition switch 124 is closed. When the generator 10 is rotating at a speed greater than a predetermined speed, the voltage on the conductor 114 goes high biasing the NPN transistor 194 conductive and connecting the junction 192 to ground. This grounds the conductor 152 so that the output of the voltage comparator 154 has no effect on the voltage regulator and the field strobing mode accordingly cannot occur. The voltage regulator now has been shifted into the normal regulation mode.

The voltage regulator of Figure 1 is capable of indicating certain faults in the circuit by energizing the signal lamp 122 when the ignition switch 124 is closed. During an overvoltage condition, which is sensed by the overvoltage comparator 86, a signal is applied to the NAND gate 96 causing the NPN transistor 126 to be biased conductive and thereby energizing the signal lamp 122. The signal lamp 122 is also energized when there is no rotation of the generator rotor (no voltage at junction 106) through the operation of the generator phase voltage responsive comparator 90 and, the NAND gate 96. If the field winding 14 is open there is no voltage developed at the junction 106 and accordingly the

signal lamp 122 is energized.

The following is a brief summary of the operation of the voltage regulator of this invention. When the operator of a motor vehicle closes the ignition switch 124 to start the engine 15 the voltage regulator is energized by virtue of the voltage developed at the junction 77. The voltage regulator will now operate in the field strobe mode with the MOSFET 38 being gated on and off to provide the previously mentioned 27% duty cycle. This causes an average current to be supplied to the field winding 14 from the storage battery 30 which provides initial excitation for the field winding 14. When the engine 15 starts it drives the rotor of the generator 10 and the generator output voltage builds up. At a certain generator rotor speed there will be a voltage developed at the junction 106 of a sufficient magnitude to cause the output of the generator phase voltage responsive comparator 90 to go high. This will cause the voltage regulator to shift from the field strobe mode to the regulation mode and will cause the signal lamp 122 to become deenergized to thereby turn it off.

The function of the low pass RC filter comprised of the resistor 42 and the gate capacitance of the MOSFET 38 in smoothing the gate voltage has been described. This low pass RC filter also reduces radio interference.

The adding or stacking of the voltage across the capacitor 116 and the voltage on the conductor 50 so as to provide a sum voltage on the conductor 120 has been described as a voltage doubling action. The voltage regulator does provide a voltage doubling action but it is arranged such that the voltage developed at the conductor 120 is not exactly double the voltage on the conductor 36. As an example, when the voltage regulator is operating in the regulation mode, the voltage regulator is preferably arranged such that maximum voltage developed at the conductor 120 (end of capacitor charge mode) is about 1.8 times the voltage on the conductor 36 and this voltage drops to about 1.65 times the voltage on the conductor 36 at the end of the discharge of the capacitor 116.

The voltage for charging the capacitor 116 and the voltage provided at the junction 139 (VREF1) are both supplied from the conductor 50 which in turn is supplied by the conductor 36 and the junction 28. The voltage of the conductor 50 varies with changes in voltage of the junction 28 and accordingly with changes in voltage across the storage battery 30. The capacitor charging voltage and voltage VREF1 therefore both change in the same direction with changes in voltage across the storage battery 30.

The consecutive occurring timing periods of the same kind that are developed in the voltage regulator of this invention are of substantially equal time periods. As one example, when the voltage regulator is operating in the regulation mode and generator output voltage is below the desired regulated value the consecutive occurring time periods $T_A$ are of equal duration as are consecutive occurring timing periods $T_B$ and $T_C$.

The flip-flop 182 checks the status of the voltage on the conductor 100 (high or low) each time a clock pulse is developed on the conductor 180. If the status of the voltage level on the conductor 100 has not changed from one clock pulse to the next occurring clock pulse the next occurring clock pulse will not cause a change in the $\overline{Q}$ output of the flip-flop 182. If a change in the voltage level on the conductor 100 has occurred just prior to a clock pulse the $\overline{Q}$ output will change state. This checking of the status of the voltage on the conductor 100 and the outputting of the appropriate gate control signal is done in a periodic fashion which is independent of the ripple frequency of the ripple voltage developed at the positive direct voltage output terminal 22 of the bridge rectifier 16. The voltage regulator accordingly is not a so-called ripple regulator.

The flip-flop 182 and associated circuitry provide a digital sample and hold function and can take other forms as long as the voltage regulator is controlled in a manner that has been described.

As previously explained, the gate voltage that is developed when the capacitor voltage is added to the voltage on the conductor 50 is high enough to bias the MOSFET 38 fully conductive and remains high enough during capacitor discharge to keep the MOSFET 38 biased fully conductive. This magnitude of gate voltage is well above the threshold voltage of the MOSFET 38 so that it is biased fully conductive or in other words, saturated.

The voltage on the conductor 50 is slightly lower than the voltage on the conductor 36 and accordingly the magnitude of the voltage that is added to the capacitor voltage when the voltages are stacked or added is a voltage magnitude that is substantially equal to the voltage across the storage battery 30.

The voltage regulator that has been described is preferably fabricated as a hybrid integrated circuit module that can be secured to a generator end frame.

## Claims

1. A switching circuit for connecting and disconnecting a voltage source and an electrical load comprising, a direct voltage source (30) having positive and negative terminals, an N-channel field effect transistor having a gate (G), a drain (D) and a source (S), conductors (36,39) connecting drain to the positive terminal of the voltage source, and an electrical load (14) connected between the source of the field effect transistor and the negative terminal, characterised by a capacitor (116), a charge circuit (170,172) for charging the capacitor, a discharge circuit (140,196) for discharging the capacitor, means (130) responsive to the voltage across the capacitor attaining a predetermined charge voltage when the capacitor is charging for disabling the charge circuit while substantially simultaneously enabling the discharge circuit to cause the capacitor to begin to discharge, means (130) responsive to the capacitor attaining the predetermined charge voltage for causing the voltage of the voltage source and the voltage attained by the capacitor to be added in series to provide a gate bias voltage that is substantially the sum of the voltage of the voltage source and the voltage attained by the capacitor and for applying the gate bias voltage to the gate to thereby provide a gate bias voltage that is high enough to bias the field effect transistor conductive between its drain and source, means (130) for sensing the gate bias voltage as the capacitor discharges and for causing the charge circuit to be re-enabled to recharge the capacitor when the gate bias voltage decreases to a predetermined value due to discharge of the capacitor, the predetermined value of gate bias voltage being high enough to maintain the field effect transistor biased conductive, and control means (46) comprising a switching means (184) for at times connecting the gate to the negative terminal to thereby cause the field effect transistor to be biased nonconductive, the switching means when nonconductive permitting the field effect transistor to be biased conductive.

2. A switching circuit as claimed in Claim 1, characterised in that the control means (46) including means for permitting a change in state of the switching means (184) only substantially at a time when the charge circuit (170,172) is disabled and the discharge circuit (140,196) enabled.

3. A switching circuit as claimed in Claim 1 or Claim 2, characterised by means (130) for sensing the voltage across the capacitor as the capacitor (116) charges and for causing the switching means (184) to be enabled to be biased conductive when the voltage across the capacitor increases to a first predetermined value due to discharge of the capacitor to thereby cause the field effect transistor (38) to be biased nonconductive, and means responsive to the gate bias voltage decreasing to a second predetermined value for causing the charge circuit (I70,I72) to be re-enabled and the discharge circuit (I40,I96) disabled, the second predetermined value being less than the first predetermined value.

4. A switching circuit as claimed in any one of Claims I to 3, characterised by a conductor (I20) connecting one end of the capacitor (II6) to a junction (I62), conductors (II8,50) connecting the opposite end of the capacitor to the positive terminal of the voltage source (30), and a conductor (40) connecting the junction to the gate (G).

5. A switching circuit as claimed in Claim 4, characterised in that the charge circuit for charging the capacitor (II6) comprises a circuit (I70,I72) connected between the positive terminal of the voltage source (30) and the junction (I62) and a second switching means (I78) connected between the opposite end of the capacitor and the negative terminal of the voltage source, in that the means (130) responsive to the voltage across the capacitor attaining the predetermined charge voltage when the capacitor is charging biases the second switching means nonconductive to thereby disable the charge circuit; and in that the means (I30) for sensing the gate bias voltage as the capacitor discharges causes the second switching means to be biased conductive to recharge the capacitor when the gate bias voltage decreases to the predetermined value.

6. A voltage regulator for a generator (I0) that has an output winding (I2) and a field winding (I4) comprising, circuit means (I6) having positive (22) and negative (24) direct voltage output terminals connected to the output winding, a field effect transistor (38) having a gate (G), a drain (D) and a source (S), conductors (39,36,26) connecting the drain to said positive direct voltage output terminal, and means connecting the field winding between the source of the field effect transistor and the negative direct voltage output terminal, characterised by a capacitor (II6), a charging circuit (I70,I72) for charging the capacitor from the direct voltage output terminals, a discharging circuit (I40,I96) for discharging said capacitor, a voltage responsive control circuit (I30) responsive to the magnitude of the voltage across the capacitor for disabling the charging circuit and enabling the discharging circuit when the voltage across the capacitor attains a predetermined value, means (I30) responsive to the capacitor attaining said predetermined value of voltage for causing the direct voltage across the direct voltage output terminals to be added in series with the voltage across the capacitor to provide a gate bias voltage that is substantially the sum of the voltage across the direct voltage output terminals and the voltage attained by the capacitor and for applying the gate bias voltage to the gate to thereby provide a gate voltage that is high enough to bias the field effect transistor conductive between its drain and source, means (I30) for sensing the gate bias voltage as the capacitor discharges and for causing the charging circuit to be re-enabled to recharge the capacitor when the gate bias voltage decreases to a predetermined value due to discharge of said capacitor, the predetermined value of gate bias voltage being high enough to maintain the field effect transistor biased conductive, a first switching means (I84) connected between the gate of the field effect transistor and the negative terminal, the first switching means when conductive causing the field effect transistor to be biased nonconductive, and control means (46) controlling the switching state of the first switching means responsive to the output voltage of the generator for causing the first switching means to become or remain biased conductive when the output voltage of the generator is above a desired regulated value and for causing the first switching means to become or remain biased nonconductive when the output voltage is below the desired regulated value, the control means including means for permitting a change in state of the first switching means only substantially at a time when the charge circuit is disabled and the discharge circuit enabled.

7. A voltage regulator as claimed in Claim 6, characterised by a junction (I62) , a conductor (I20) connecting an end of the capacitor (II6) to the junction, conductors (II8,50,36) connecting an opposite end of the capacitor to the positive direct voltage input terminal (22), a conductor (40) connecting the junction to the gate (G); in that the charge circuit comprises a circuit (I70,I72) that is connected between the positive direct voltage input terminal and the junction and a second switching means (I78) that is connected between the opposite end of the capacitor and the negative direct voltage input terminal (24), the capacitor charging through the second switching means when it is conductive; in that the voltage responsive control ciruit (I30) is connected to the junction and biases the second switching means nonconductive to thereby disable the charge circuit, when the second switching means is biased nonconductive, in that the means (l30) for sensing the gate bias voltage as the capacitor discharges causes the second switching means to be biased conductive to recharge the capacitor when the gate bias voltage decreases to the predetermined value, in that the first switching means (l84) when nonconductive permits the gate bias voltage developed at the junction to bias the field effect transistor (38) conductive; and in that the control means (46) is responsive to the switching state of the second switching means.

8. A voltage regulator as claimed in Claim 7 wherein a resistor (42) is connected between the gate (G) and junction (l62), the resistor and the gate capacitance of the field effect transistor (38) forming a filter circuit to smooth the voltage applied to the gate from the junction.

9. A voltage regulator as claimed in Claim 7 wherein the voltage regulator includes strobe control means responsive to the output voltage of the generator for shifting the voltage regulator into a strobing mode wherein the field effect transistor (38) is biased conductive for consecutive occurring periods of time that have a predetermined duty cycle, the voltage regulator being shifted into the strobing mode when the output voltage of the generator (l0) is zero or below a predetermined value, a third switching means (l86) connected between the gate (G) and the negative direct voltage output terminal (24), the voltage regulator when in the strobing mode including means (l94) operative to cause the third switching means to be biased conductive when said gate voltage decreases to a voltage level that is higher in voltage magnitude than the predetermined voltage value that causes the capacitor (ll6) to recharge during the time that the capacitor is discharging.

10. A voltage regulator as claimed in any one of Claims 7 to 9 characterised by means for repetitively charging and discharging the capacitor (ll6) and for causing the gate bias voltage that is developed at the junction (l62) to be substantially equal to the sum of the capacitor voltage and the voltage across the positive and negative direct voltage output terminals (22,24) when capacitor charging is terminated and capacitor discharge begins, means for causing the capacitor to be recharged and capacitor discharge terminated when the gate bias voltage decreases to the predetermined value during discharge of the capacitor, the consecutive occurring charge and discharge periods of the capacitor being substantially equal to a timing period, the control means causing the field effect transistor (38) to be biased conductive for a total time period that is substantially equal to the sum of a plurality of timing periods when the output voltage of the generator (l0) is below the desired regulated value and for causing the field effect transistor to be biased nonconductive for a total time period that is substantially equal to the sum of a plurality of timing periods when the output voltage of the generator is above the desired regulated value.

11. A voltage regulator as claimed in Claim l0 wherein means are provided to cause the discharge period of the capacitor (ll6) to be shorter when the output voltage of the generator (l0) is above the desired regulated value than it is when the generator output voltage is below the desired regulated value.

12. A voltage regulator as claimed in Claim l0 wherein the control means includes means for permitting a change in switching state of the field effect transistor (38) only substantially at a time when the capacitor charge period terminates and the capacitor discharge period begins.

13. A voltage regulator as claimed in any one of Claims 6 to l2 for use with a diode-rectified alternating current generator (l0) that supplies the electrical loads on a motor vehicle including the charging of a storage battery (30) and comprises an alternating current generator (l0) having a rotor driven by the engine (l5), rectifier means (l6) connected to the output winding (l2) and having the positive and negative direct voltage output terminals (22,24), and a storage battery (30) connected across the direct voltage output terminals.

**Revendications**

1. Circuit de commutation pour connecter et déconnecter une source de tension et une charge électrique comprenant une source de tension continue (30) possédant des bornes positive et négative, un transistor à effet de champ à canal N possédant une grille (G), un drain (D) et une source (S), des conducteurs (36,39) raccordant le drain à la borne positive de la source de tension, et une charge électrique (14) branchée entre la source du transistor à effet de champ et la borne négative, caractérisé par un condensateur (116), un circuit de charge (170,172) servant à charger le condensateur, un circuit de décharge (140,196) servant à décharger le condensateur, des moyens (130) aptes à répondre au fait que la tension aux bornes du condensateur atteint une tension de charge prédéterminée lorsque le condensateur se charge, pour invalider le circuit de charge tout en autorisant sensiblement simultanément le circuit de décharge à déclencher le début de la décharge du condensateur, des moyens (130) aptes à répondre au fait que le condensateur atteint la tension de charge prédéterminée de manière à réaliser l'addition en série de la tension de la source de tension et de la tension atteinte par le condensateur pour fournir une tension de polarisation de grille qui est égale sensiblement à la somme de la tension de la source de tension et de la tension atteinte par le condensateur et appliquer la tension de polarisation de grille à la grille de manière à obtenir de ce fait une tension de polarisation de grille suffisamment élevée pour placer le transistor à effet de champ à l'état conducteur entre son drain et sa source, des moyens (130) aptes à détecter la tension de grille lorsque le condensateur se décharge et à autoriser à nouveau une recharge du condensateur par le circuit de charge lorsque la tension de polarisation de grille tombe à une valeur prédéterminée sous l'effet de la décharge du condensateur, la valeur prédéterminée de la tension de polarisation de grille étant suffisamment élevée pour maintenir le transistor à effet de champ à l'état conducteur, et des moyens de commande (46) comprenant des moyens de commutation (184) permettant de raccorder tout moment la grille à la borne négative afin de placer de cette manière le transistor à effet de champ à l'état bloqué, les moyens de commutation permettant, lorsqu'ils sont bloqués, la mise à l'état conducteur du transistor à effet de champ.

2. Circuit de commutation selon la revendication 1, caractérisé en ce que les moyens de commande (46) comprennent des moyens permettant une modification de l'état des moyens de commutation (184) seulement sensiblement à l'instant où le circuit de charge (170,172) est invalidé et où le circuit de décharge (140,196) est validé.

3. Circuit de commutation selon la revendication 1 ou 2, caractérisé par des moyens (130) pour détecter la tension aux bornes du condensateur lorsque le condensateur (116) se charge et permettre aux moyens de commutation (184) d'être placés à l'état conducteur lorsque la tension aux bornes du condensateur augmente à une première valeur prédéterminée sous l'effet de la décharge du condensateur de manière à placer à l'état bloqué le transistor à effet de champ (38), et des moyens aptes à répondre au fait que la tension de polarisation de grille décroît à une seconde valeur prédéterminée pour valider à nouveau le circuit de charge (170,172) et invalider le circuit de décharge (140,196), la seconde valeur prédéterminée étant inférieure à la première valeur prédéterminée.

4. Circuit de commutation selon l'une quelconque des revendications 1 à 3, caractérisé par un conducteur (120) raccordé à une extrémité du condensateur (116) et à une jonction (162), des conducteurs (118,50) raccordant l'extrémité opposée du condensateur à la borne positive de la source de tension (30), et un conducteur (40) raccordant la jonction à la grille (G).

5. Circuit de commutation selon la revendication 4, caractérisé en ce que le circuit de charge servant à charger le condensateur (116) comprend un circuit (170,172) branché entre la borne positive de la source de tension (30) et la jonction (162), et des seconds moyens de commutation (178) branchés entre l'extrémité opposée du condensateur et la borne négative de la source de tension, en ce que les moyens aptes à répondre au fait que la tension aux bornes du condensateur atteint la tension de charge prédéterminée lorsque le condensateur se charge, placent à l'état bloqué les seconds moyens de commutation de manière à invalider le circuit de charge; et en ce que les moyens (130) servant à détecter la tension de polarisation de grille lorsque le condensateur se décharge provoquent la mise à l'état conducteur des seconds moyens de commutation de manière à recharger le condensateur lorsque la tension de polarisation de grille tombe à la valeur prédéterminée.

6. Régulateur de tension pour un générateur (10) qui possède un enroulement de sortie (12) et un enroulement de champ (14) et comprenant des moyens formant circuit (16) possédant des bornes de sortie de tension continue positive (22) et négative (24), raccordées à l'enroulement de sortie, un transistor à effet de champ (38) possédant une grille (G), un drain (D) et une source (S), des conducteurs (39,36,26) raccordant le drain à ladite borne positive de sortie de la tension continue, et des moyens raccordant l'enroulement de champ entre la source du transistor à effet de champ et la borne négative de sortie de tension continue, caractérisé par un condensateur (116) et un circuit de charge (170,172) servant à charger le condensateur à partir des bornes de sortie de tension continue, un circuit de décharge (140,196) servant à décharger ledit condensateur, un circuit de commande (130) sensible à une tension et apte à répondre à l'amplitude de la tension aux bornes du condensateur pour invalider le circuit de charge et valider le circuit de décharge lorsque la tension aux bornes du condensateur atteint une valeur prédéterminée, des moyens (130) aptes à répondre au fait que le condensateur atteint ladite valeur prédéterminée de tension pour déclencher l'addition en série de la tension continue, présente entre les bornes de sortie de tension continue, et de la tension aux bornes du condensateur de manière à produire une tension de polarisation de grille égale sensiblement à la somme de la tension présente entre les bornes de sortie de tension continue et la tension atteinte par le condensateur, et appliquer la tension de polarisation de grille à la grille de manière à fournir une tension de grille suffisamment élevée pour placer à l'état conducteur le transistor à effet de champ, entre son drain et sa source, des moyens (130) pour détecter la tension de polarisation de grille lorsque le condensateur se décharge et valider à nouveau le circuit de charge pour qu'il recharge le condensateur lorsque la tension de polarisation de grille tombe à une valeur prédéterminée sous l'effet de la décharge dudit condensateur, la valeur prédéterminée de la tension de polarisation de grille étant suffisamment élevée pour maintenir à l'état conducteur le transistor à effet de champ, des premiers moyens de commutation (184) branchés entre la grille du transistor à effet de champ et la borne négative, les premiers moyens de commutation provoquant, lorsqu'ils sont conducteurs, la mise à l'état non conducteur du transistor à effet de champ, et des moyens de commande (46) commandant l'état de commutation des premiers moyens de commutation aptes à répondre à la tension de sortie du générateur pour placer ou maintenir à l'état conducteur les premiers moyens de commutation lorsque la tension de sortie du générateur est supérieure à une valeur régulée désirée, et amener ou maintenir à l'état bloqué les premiers moyens de commutation lorsque la tension de sortie est inférieure à la valeur régulée désirée, les moyens de commande comprenant des moyens pour permettre un changement de l'état des premiers moyens de commutation seulement essentiellement à un instant où le circuit de charge est invalidé et où le circuit de décharge est validé.

7. Régulateur de tension selon la revendication 6, caractérisé par une jonction (162), un conducteur (120) raccordant une extrémité du condensateur (116) à la jonction, des conducteurs (118,50,36) raccordant une extrémité opposée du condensateur à la borne positive (22) d'entrée de la tension continue, un conducteur (40) raccordant la jonction à la grille (G); et en ce que le circuit de charge comprend un circuit (170,172) qui est branché entre la borne positive d'entrée de la tension continue et la jonction, et des seconds moyens de commutation (178), qui sont branchés entre l'extrémité opposée du condensateur et la borne négative (24) d'entrée de la tension continue, le condensateur se chargeant par l'intermédiaire des seconds moyens de commutation lorsqu'il est conducteur; en ce que le circuit de commande (130) sensible à la tension est raccordé à la jonction et place à l'état bloqué les seconds moyens de commutation de manière à invalider le circuit de charge lorsque les seconds moyens de commutation sont placés à l'état bloqué, en ce que les moyens (130) servant à détecter la tension de polarisation de grille lorsque le condensateur se décharge déclenchent la mise à l'état conducteur des seconds moyens de commutation pour recharger le condensateur lorsque la tension de polarisation de grille tombe à la valeur prédéterminée, en ce que les premiers moyens de commutation (184) permettent, lorsqu'ils sont bloqués, à la tension de polarisation de grille développée au niveau de la jonction de placer à l'état conducteur le transistor à effet de champ (38); et en ce que les moyens de commande (46) sont sensibles à l'état de commutation des seconds moyens de commutation.

8. Régulateur de tension selon la revendication 7, dans lequel une résistance (42) est branchée entre la grille (G) et la jonction (162), la résistance et la capacité de grille du transistor à effet de champ (38) constituant un circuit de filtre servant à lisser la tension appliquée à la grille à partir de la jonction.

9. Régulateur de tension selon la revendication 7, dans lequel le régulateur de tension comprend des moyens de commande d'échantillonnage aptes à répondre à la tension de sortie du générateur pour commuter le régulateur de tension dans un mode d'échantillonnage, dans lequel le transistor à effet de champ (38) est placé à l'état conducteur pendant les intervalles de temps successifs qui présentent un taux d'impulsions prédéterminé, le régulateur de tension étant commuté dans le mode d'échantillonnage lorsque la tension de sortie du générateur (10) est nulle ou inférieure à une valeur prédéterminée, des troisièmes moyens de commutation (186) branchés entre la grille (G) et la borne négative (24) de sortie de la tension continue, et dans lequel, lorsqu'il est dans le mode d'échantillonnage, le régulateur de tension comprend des moyens (194) agissant de manière à placer à l'état conducteur les troisièmes moyens de commutation lorsque ladite tension de grille tombe à un niveau de tension, dont l'amplitude est supérieure à la valeur de tension prédéterminée qui provoque la recharge du condensateur (116) pendant l'intervalle de temps pendant lequel le condensateur se décharge.

10. Régulateur de tension selon l'une quelconque des revendications 7 à 9, caractérisé par des moyens pour charger et décharger de façon répétitive le condensateur (116) et rendre la tension de polarisation de grille, qui apparaît au niveau de la jonction (162), sensiblement égale à la somme de la tension aux bornes du condensateur et de la tension entre les bornes positive et négative (22,24) de sortie de la tension continue lorsque la charge du condensateur est terminée et que la décharge du condensateur commence, des moyens pour déclencher la recharge du condensateur et arrêter la décharge du condensateur lorsque la tension de polarisation de grille tombe à la valeur prédéterminée pendant la décharge du condensateur, les périodes successives de charge et de décharge du condensateur étant sensiblement égales à une période de cadencement, les moyens de commande plaçant à l'état conducteur le transistor à effet de champ (38) pendant un intervalle de temps global sensiblement égal à la somme d'une pluralité de périodes de cadencement pendant lesquelles la tension de sortie du générateur (10) est inférieure à la valeur réglée désirée, et plaçant à l'état bloqué le transistor à effet de champ pendant un intervalle de temps global sensiblement égal à la somme d'une pluralité de périodes de cadencement lorsque la tension de sortie du générateur est supérieure à la valeur réglée désirée.

11. Régulateur de tension selon la revendication 10, dans lequel des moyens sont prévus pour rendre la période de décharge du condensateur (116), lorsque la tension de sortie du générateur (10) est supérieure à la valeur réglée désirée, inférieure à ce qu'elle est lorsque la tension de sortie du générateur est inférieure à la valeur réglée désirée.

12. Régulateur de tension selon la revendication 10, dans lequel les moyens de commande incluent des moyens pour permettre une modification de l'état de commutation du transistor à effet de champ (38) seulement sensiblement à l'instant où la période de charge du condensateur se termine et où la période de décharge du condensateur commence.

13. Régulateur de tension selon l'une quelconque des revendications 6 à 12, destiné à être utilisé avec un générateur (10) de courant alternatif redressé par une diode, qui alimente les charges électriques dans un véhicule automobile, y compris la charge d'une batterie d'accumulateurs (30), et comprend un générateur de courant alternatif (10) possédant un rotor entraîné par le moteur (15), des moyens redresseurs (16) raccordés à l'enroulement de sortie (12) et comportant les bornes positive et négative (22,24) de sortie de la tension continue, et une batterie d'accumulateurs (30) raccordée aux bornes de sortie de la tension continue.

**Patentansprüche**

1. Schaltkreis zum Anschließen und Abtrennen einer Spannungsquelle an bzw. von einer elektrischen Last, welcher umfaßt eine Gleichspannungsquelle (30) mit einer positiven und einer negativen Klemme, einen N-Kanal-Feldeffekt-Transistor mit einem Gate- (G), einem Drain- (D) und einem Source-Anschluß (S), den Drainanschluß mit der positiven Klemme der Spannungsquelle verbindende Leiter (36, 39) und eine zwischen dem Sourceanschluß des Feldeffekt-transistors und der negativen Klemme angeschlossene elektrischen Last (14), gekennzeichnet durch einen Kondensator (116), eine Ladeschaltung (170, 172) zum Aufladen des Kondensators, eine Entladeschaltung (140, 196) zum Entladen des Kondensators, Mittel (130), das, wenn die Spannung über dem Kondensator beim Aufladen des Kondensators eine vorbestimmte Ladespannung erreicht, reagiert durch Sperren der Ladeschaltung bei im wesentlichen gleichzeitigen Freigeben der Entladeschaltung, um die Entladung des Kondensators beginnen zu lassen, Mittel (130), das, wenn der Kondensator die vorbestimmte Ladespannung erreicht, reagiert durch Summieren der Spannung der Spannungsquelle in Reihe mit der durch den Kondensator erreichten Spannung, um eine Gate-Vorspannung zu schaffen, die im wesentlichen die Summe aus der Spannung der Spannungsquelle und der durch den Kondensator erreichten Spannung ist, und durch Anlegen der Gate-Vorspannung an den Gateanschluß, um dadurch eine genügend hohe Gate-Vorspannung zu schaffen, damit der Feldeffekt-Transistor zwischen seinen Drain- und Source-Anschlüssen leitend wird, Mittel (130), um die Gate-Vorspannung beim Entladen des Kondensators zu erfassen und die Ladeschaltung zum Wiederaufladen des Kondensators wieder freizugeben, wenn die Gate-Vorspannung durch Entladen des Kondensators auf einen vorbestimmten Wert abfällt, wobei der vorbestimmte Wert der Gate-Vorspannung ausreichend hoch ist, um den Feldeffekt-Transistor in den Leitbereich vorgespannt sein zu lassen, und Steuermittel (46), das ein Schaltermittel (184) umfaßt zum zeitweiligen Verbinden des Gate-Anschlusses mit der negativen Klemme, um dadurch den Feldeffekt-Transistor nichtleitend vorgespannt werden zu lassen, wobei das Schaltermittel im nichtleitenden Zustand zuläßt, daß der Feldeffekt-Transistor leitend vorgespannt wird.

2. Schaltkreis nach Anspruch 1, dadurch gekennzeichnet, daß das Steuermittel (46) Mittel enthält, um eine Änderung des Zustandes des Schaltmittels (184) erst im wesentlichen zu einer Zeit zuzulassen, wenn die Ladeschaltung (170, 172) gesperrt und die Entladeschaltung (140, 196) freigegeben ist.

3. Schaltkreis nach Anspruch 1 oder 2, gekennzeichnet durch Mittel (130) zum Erfassen der Spannung über dem Kondensator, wenn der Kondensator (116) lädt, und um das Schaltermittel (184) freigegeben sein zu lassen, um leitend vorgespannt zu werden, wenn die Spannung über dem Kondensator infolge der Entladung des Kondensators auf einen ersten vorbestimmten Wert ansteigt, um dadurch den Feldeffekt-Transistor (38) nichtleitend vorgespannt sein zu lassen, und ittel, das auf das Abnehmen der Gate-Vorspannung auf einen zweiten vorbestimmten Wert reagiert, indem es die Ladeschaltung (170, 172) wieder freigegeben und die Entladeschaltung (140, 196) gesperrt sein läßt, wobei der zweite vorbestimmte Wert geringer als der erste vorbestimmte Wert ist.

4. Schaltkreis nach einem der Ansprüche 1 bis 3, gekennzeichnet durch einen ein Ende des Kondensators (116) mit einer Verbindungsstelle (162) verbindenden Leiter (120), das gegenüberliegende Ende des Kondensators mit der positiven Klemme der Spannungsquelle (30) verbindende Leiter (118, 50) und einen die Verbindungsstelle mit dem Gate (G) verbinden- . den Leiter (40).

5. Schaltkreis nach Anspruch 4, dadurch gekennzeichnet, daß die Ladeschaltung zum Aufladen des Kondensators (116) eine zwischen der positiven Klemme der Spannungsquelle (30) und der Verbindungsstelle (162) angeschlossene Schaltung (170, 172) und ein zweites Schaltermittel (178) umfaßt, das zwischen dem gegenüberliegenden Ende des Kondensators und der negativen Klemme der Spannungsquelle angeschlossen ist, daß das Mittel (130), welches reagiert, wenn während des Ladens des Kondensators die Spannung über dem Kondensator die vorbestimmte Ladespannung erreicht, das zweite Schaltermittel in Nichtleitung vorspannt, um dadurch die Ladeschaltung zu sperren; und daß das Mittel (130) zum Erfassung der Gate-Vorspannung beim Entladen des Kondensators das zweite Schaltermittel zum Wiederladen des Kondensators leitend vorgespannt sein läßt, wenn die Gate-Vorspannung auf den vorbestimmten Wert abnimmt.

6. Spannungsregler für einen Generator (10), der eine Ausgangswicklung (12) und eine Feldwicklung (14) besitzt, welcher umfaßt Schaltungsmittel (16) mit positiven (22) und negativen (24) Gleichspannungs-Ausgangsklemmen, die mit der Ausgangswicklung verbunden sind, einen Feldeffekt-Transistor (38) mit einem Gate- (G), einem Drain-(D) und einem Source-Anschluß (S), den Drain-Anschluß mit der positiven Gleichspannungs-Ausgangsklemme verbindende Leiter (39, 36, 26) und die Feldwicklung zwischen dem Source-Anschluß des Feldeffekt-Transistors und der negativen Gleichspannungs-Ausgangsklemme anschließende Mittel, gekennzeichnet durch einen Kondensator (116), eine Ladeschaltung (170, 172) zum Aufladen des Kondensators von den Gleichspannungs-Ausgangsklemmen, eine Entladeschaltung (140, 196) zum Entladen des Kondensators, eine spannungsabhängige Steuerschaltung (130), die auf die Größe der Spannung über dem Kondensator reagiert zum Sperren der Ladeschaltung und Freigeben der Entladeschaltung, wenn die Spannung über dem Kondensator einen vorbestimmten Wert erreicht, Mittel (130), die auf das Erreichen des vorbestimmten Spannungswertes durch den Kondensator reagieren, um die über den Gleichspannungs-Ausgangsklemmen liegende Gleichspannung in Reihe zu der Spannung

17

über dem Kondensator addieren zu lassen und eine Gate-Vorspannung zu schaffen, die im wesentlichen die Summe der Spannung über den Gleichspannungs-Ausgangsklemmen und der durch den Kondensator erreichten Spannung ist, und zum Anlagen der Gate-Vorspannung an das Gate, um dadurch eine Gate-Vorspannung zu schaffen, die genügend hoch ist, um den Feldeffekt-Transistor zwischen seinem Drain- und Source-Anschluß leitend vorzuspannen, Mittel, um die Gate-Vorspannung beim Entladen des Kondensators zu erfassen und die Ladeschaltung wieder freigeben zu lassen, um den Kondensator aufzuladen, wenn die Gate-Vorspannung infolge des Entladens des Kondensators auf einen vorbestimmten Wert abnimmt, wobei der vorestimmte Wert der Gate-Vorspannung hoch genug ist, um den Feldeffekt-Transistor leitend vorgespannt zu halten, ein erstes zwischen dem Gate-Anschluß des Feldeffekt-Transistors und der negativen Klemme angeschlossenes Schaltermittel (184), wobei das erste Schaltermittel im Leitzustand den Feldeffekt-Transistor nichtleitend vorgespannt sein läßt, und den Schaltzustand des ersten Schaltermittels steuerndes Steuermittel (46), das auf die Ausgangsspannung des Generators reagiert, um das erste Schaltermittel leitend vorgespannt werden oder bleiben zu lassen, wenn die Ausgangsspannung des Generators über einem gewünschten regulierten Wert ist, und das erste Schaltermittel nichtleitend vorgespannt werden oder bleiben zu lassen, wenn die Ausgangsspannung sich unter dem erwünschten regulierten Wert befindet, wobei das Steuermittel Mittel enthält, um eine Änderung im Zustand des ersten Schaltermittels nur im wesentlichen zu dem Zeitpunkt zuzulassen, wenn die Ladeschaltung gesperrt und die Entladeschaltung freigegeben wird.

7.  Spannungsregler nach Anspruch 6, gekennzeichnet durch eine Verbindungsstelle (162), einen ein Ende des Kondensators (116) mit der Verbindungsstelle verbindenden Leiter (120), ein entgegengesetzt liegendes Ende des Kondensators mit der positiven Gleichspannungs-Eingangsklemme (22) verbindende Leiter (118, 50, 36), einen die Verbindungsstelle mit dem Gate-Anschluß (G) verbindenden Leiter (40); und dadurch, daß die Ladeschaltung eine Schaltung (170, 172) umfaßt, die zwischen der positiven Gleichspannungs-Eingangsklemme und der Verbindungsstelle angeschlossen ist, und ein zweites Schaltermittel (178), das zwischen dem entgegengesetzt liegenden Ende des Kondensators und der negativen Gleichspannungs-Eingangsklemme (24) angeschlossen ist, wobei der Kondensator durch das zweite Schaltermitel auflädt, wenn es leitend ist; daß die spannungsabhängige Steuerschaltung (130) mit der Verbindungsstelle verbunden ist und das zweite Schaltermittel nichtleitend vorspannt, um dadurch die Ladeschaltung zu sperren, wenn das zweite Schaltermittel nichtleitend vorgespannt ist, daß das Mittel (130) zum Erfassen der Gate-Vorspannung beim Entladen des Kondensators das zweite Schaltermittel leitend vorgespannt sein läßt, um den Kondensator wieder aufzuladen, wenn die Gate-Vorspannung auf den vorbestimmten Wert abnimmt, daß das erste Schaltermittel (184), wenn es nichtleitend ist, die an der Verbindungsstelle entwickelte Gate-Vorspannung den Feldeffekt-Transistor (38) leitend vorspannen läßt; und daß das Steuermittel (46) auf den Schaltzustand des zweiten Schaltermittels reagiert.

8.  Spannungsregler nach Anspruch 7, bei dem ein Widerstand (42) zwischen dem Gate-Anschluß (G) und der Verbindungsstelle (162) angeschlossen ist, wobei der Widerstand und die Kapazität des Gates des Feldeffekt-Transistors (38) einen Filterkreis bilden, um die an dem Gate-Anschluß von der Verbindungsstelle her angeliegende Spannung zu glätten.

9.  Spannungsregler nach Anspruch 7, bei dem Spannungsregler Impulsspitzen-Steuermittel enthält, die auf die Ausgangsspannung des Generators reagieren, um den Spannungsregler in einen Impulstaktmodus zu verschieben, bei dem der Feldeffekt-Transistor (38) für aufeinanderfolgend auftretende Zeiträume mit einem vorbestimmten relativen Einschaltverhältnis leitend vorgespannt wird, der Spannungsregler in den Impulstaktmodus verschoben wird, wenn die Ausgangsspannung des Generators (10) Null oder unter einem vorbestimmten Wert ist, ein drittes Schaltermittel (186) zwischen dem Gate-Anschluß (G) und der negativen Gleichspannungs-Ausgangsklemme (24) angeschlossen ist, der im Impulstaktmodus befindliche Spannungsregler Mittel (194) enthält, die wirksam sind, das dritte Schaltermittel leitend vorgespannt sein zu lassen, wenn die Gate-Spannung während der Zeit, in der der Kondensator entlädt, auf einen Spannungspegel absinkt, dessen Spannungsgröße höher ist als der vorbestimmte Spannungswert, der den Kondensator (116) wiederaufladen läßt.

10. Spannungsregler nach einem der Ansprüche 7 bis 9, gekennzeichnet durch Mittel zum wiederholten Aufladen und Entladen des Kondensators (116), und um die an der Verbindungsstelle (162) entwickelte Gate-Vorspannung im wesentlichen gleich der Summe aus Kondensatorspannung und der Spannung über den positiven und negativen Gleichspannungs-Ausgangsklemmen (22, 24) sein zu lassen, wenn die Kondensatoraufladung beendet ist und die Kondensatorentladung beginnt, Mittel, um den Kondensator aufladen zu lassen und die Kondensatorentladung zu beenden, wenn die Gate-Vorspannung während des Entladens des Kondensators auf den vorbestimten Wert abnimmt, wobei die aufeinanderfolgend auftretenden Lade- und Entladezeiten des Kondensators im wesentlichen gleich einer Zeitablauf-Länge sind, das Steuermittel den Feldeffekt-Transistor (38) während einer Gesamtzeitlänge leitend vorgespannt sein läßt, die im wesentlichen gleich der Summe aus einer Vielzahl von Zeitablauf-Längen ist, in denen sich die Ausgangsspannung des Generators (10) unter dem erforderlichen regulierten Wert befindet, und den Feldeffekt-Transistor während einer Gesamtzeit-Länge nichtleitend vorgespannt sein zu lassen, die im wesentlichen gleich der Summe aus einer Vielzahl von Zeitablauflängen ist, in denen die Ausgangsspannung des Generators über dem gewünschten regulierten Wert liegt.

11. Spannungsregler nach Anspruch 10, bei dem Mittel vorgesehen sind, um die Entladezeitlänge des Kondensators (116) kürzer sein zu lassen, wenn die Ausgangsspannung des Generators (10) über dem gewünschten regulierten Wert liegt, als sie ist, wenn die Generator-Ausgangsspannung unter dem gewünschten regulierten Wert liegt.

12. Spannungsregler nach Anspruch 10, bei dem das Steuermittel Mittel enthält, um eine Änderung des Schaltzustandes des Feldeffekt-Transistors (38) nur im wesentlichen an einem Zeitpunkt zuzulassen, an dem die Kondensator-Ladezeit endet und die Kondensator-Entladezeit beginnt.

13. Spannungsregler nach einem der Ansprüche 6 bis 12 zur Verwendung mit einem diodengleichgerichteten Wechselstromgenerator (10), der die elektrischen Lasten bei einem Kraftfahrzeug versorgt einschließlich des Aufladens einer Speicherbatterie (30), und einen Wechselstromgenerator (10) umfaßt mit einem durch die Maschine (15) angetriebenen Rotor, wobei Gleichrichtermittel (16) mit der Ausgangswicklung (12) verbunden sind und positive und negative Gleichspannungs-Ausgangsklemmen (22, 24) besitzen, und eine Speicherbatterie (30) an den Gleichspannungs-Ausgangsklemmen angeschlossen ist.

Fig.1

EP 0 229 482 B1

*Fig.2*

*Fig.3*

EP 0 229 482 B1